# FASCICULE DE BREVET EUROPEEN

(11) **EP 2 539 721 B1**
(45) Date de publication et mention de la délivrance du brevet: **11.05.2016**
(21) Numéro de dépôt: 11705455.1
(22) Date de dépôt: 21.02.2011
(51) Int. Cl.: G01R 11/04, H02B 1/44

(54) **COMPTEUR ELECTRIQUE EQUIPE D'UN CACHE AMOVIBLE POSITIONNABLE EN DEUX POSITIONS**
ELEKTRISCHER ZÄHLER MIT IN ZWEI POSITIONEN POSITIONIERBARER ABNEHMBARER ABDECKUNG
ELECTRIC METER EQUIPPED WITH A REMOVABLE COVER THAT CAN BE POSITIONED IN TWO POSITIONS

(30) Priorité: 24.02.2010 FR 1051328
(43) Date de publication de la demande: 02.01.2013
(73) Titulaire: Sagemcom Energy & Telecom SAS, 92500 Rueil-Malmaison (FR)
(72) Inventeur: ROLLAND, Patrick, 92500 Rueil-Malmaison (FR)
(74) Mandataire: Lavialle, Bruno François Stéphane
(86) Numéro de dépôt international: PCT/EP2011/000822
(87) Numéro de publication internationale: WO 2011/103991

(56) Documents cités:
- US-A- 2 182 603
- US-A- 2 279 165
- US-A- 3 087 097
- US-B1- 6 280 805

## Description

La présente invention concerne un compteur électrique comportant un cache amovible positionnable en deux positions sur le compteur.

### ARRIERE PLAN DE L'INVENTION

On connaît déjà de l'art antérieur des compteurs électriques comprenant un boîtier délimitant un bornier agencé pour permettre le raccordement de câbles électriques au compteur. Le compteur comprend un cache couvrant le bornier pour empêcher l'accès aux différentes connections électriques du compteur. Par ailleurs, un tel cache comporte généralement, sur sa face interne, un schéma de câblage permettant à un utilisateur, lors d'une intervention sur le compteur, de réaliser ou de vérifier, si les raccordements électriques correspondent au schéma.

De tels compteurs électriques sont décrits dans les documents US 2 182 603 A, US 3 087 097 A, US 2 279 165 A, US 6 280 805 B1.

Les solutions de l'art antérieur ne proposent aucun dispositif permettant à l'opérateur, de maintenir dans son champ de vision les schémas de câblage tout en ayant les mains libérées. Cela nécessite donc que l'opérateur réalisant la connexion des câbles maintienne le cache dans son champ de vision tout en tenant les câbles et l'outil nécessaire à cette opération. On imagine aisément la difficulté de la chose pour un opérateur normalement constitué.

### OBJET DE L'INVENTION

Le but de l'invention est donc proposer une solution simple permettant de maintenir le cache d'un compteur électrique en position fermée mais également en position ouverte pour faciliter la réalisation des connexions.

### BREVE DESCRIPTION DE L'INVENTION

A cet effet, l'invention a pour objet un compteur électrique comportant un boîtier délimitant un bornier de connexion à des câbles et un cache amovible recouvrant au moins partiellement le bornier. Le compteur comporte un moyen de fixation agencé pour maintenir ledit cache sur une face avant du boîtier en découvrant le bornier et en laissant apparente une face interne du cache pour un utilisateur situé en regard de la face avant du boîtier.

La fixation du cache au voisinage de la zone de connexions électriques en question permet ainsi d'accéder facilement aux informations propres au montage et au câblage du compteur et cela sans que le cache soit posé au sol, maintenu manuellement ou que ce dernier soit égaré lors d'une intervention d'un utilisateur.

Selon un premier mode de réalisation, le moyen de fixation du dispositif est une vis de type quart de tour, prisonnière du cache, comportant un corps d'ancrage surmonté d'une tête, le corps étant agencé pour maintenir le cache sur le boîtier en recouvrant le bornier et le boîtier comportant un logement pour recevoir la tête et maintenir le cache sur le boîtier en découvrant le bornier.

La vis quart de tour assure ainsi une double fonction puisqu'elle permet de fixer le cache dans deux positions distinctes. C'est une solution idéale puisqu'ainsi aucune pièce supplémentaire n'est requise et que, par ailleurs, la vie quart de tour peut est rendue imperdable. Bien entendu, ce principe peut aussi utiliser une pièce dédiée.

Avantageusement, la vis est montée mobile axialement entre une première position dans laquelle la tête est noyée dans le cache pour permettre la fixation du cache sur le boîtier par-dessus le bornier et une deuxième position dans laquelle la tête est en saillie du cache pour permettre l'insertion de la tête dans le logement du boîtier.

Selon un deuxième mode de réalisation, le moyen de fixation du dispositif est une butée disposée sur le boîtier pour retenir le cache lorsque celui-ci découvre le bornier.

Ainsi, le cache est maintenu en place simplement par la butée.

De préférence, la butée est positionnée de manière que le cache soit déformé lorsque le cache est en butée et en position sur le boîtier pour laisser le bornier découvert.

Ceci permet de maintenir le cache fermement en position.

### BREVE DESCRIPTION DES DESSINS

D'autres caractéristiques et avantages de l'invention apparaîtront à la lecture de la description qui suit de modes de réalisation particuliers de l'invention en relation avec les figures ci-jointes parmi lesquelles :
- la figure 1 est une vue de face d'un premier mode de réalisation selon l'invention, le cache étant en position fermée ;
- la figure 2 est une vue de face du premier mode de réalisation selon l'invention, le cache étant en position ouverte ;
- la figure 3 est une vue en perspective d'une vis quart de tour utilisée dans le premier mode de réalisation ;
- la figure 4 est une vue de face d'un deuxième mode de réalisation selon l'invention, le cache étant en position fermée ;
- la figure 5 est une vue de face du deuxième mode de réalisation selon l'invention, le cache étant en position ouverte.

### DESCRIPTION DETAILLEE DE L'INVENTION

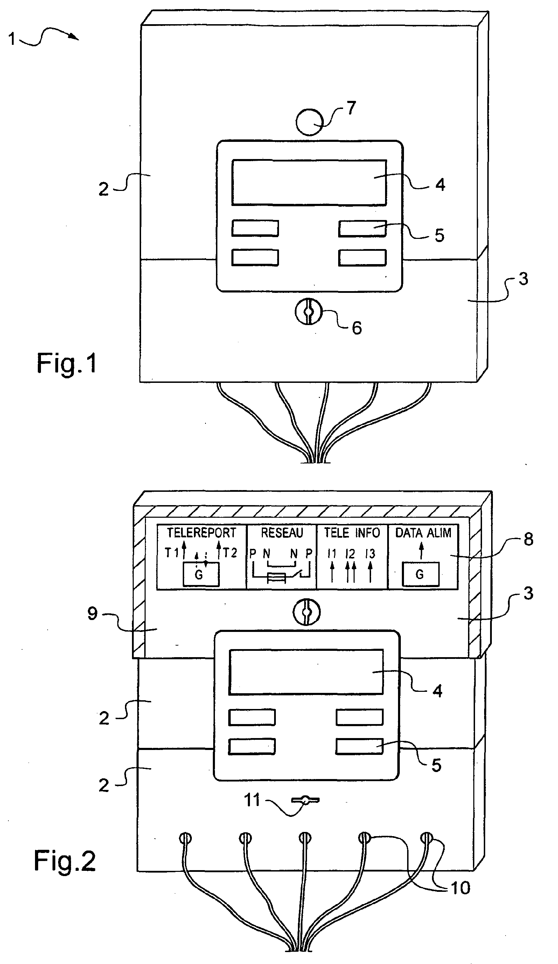

En référence à la figure 1, le compteur électrique 1 comporte un boîtier 2 dans lequel viennent se loger différents éléments électrotechniques servant à mesurer une quantité d'énergie consommée, un cache 3 obturant un bornier de connexion, un cadran 4 d'affichage d'informations reflétant une consommation énergétique et différents boutons permettant de contrôler les différentes fonctions du compteur électrique.

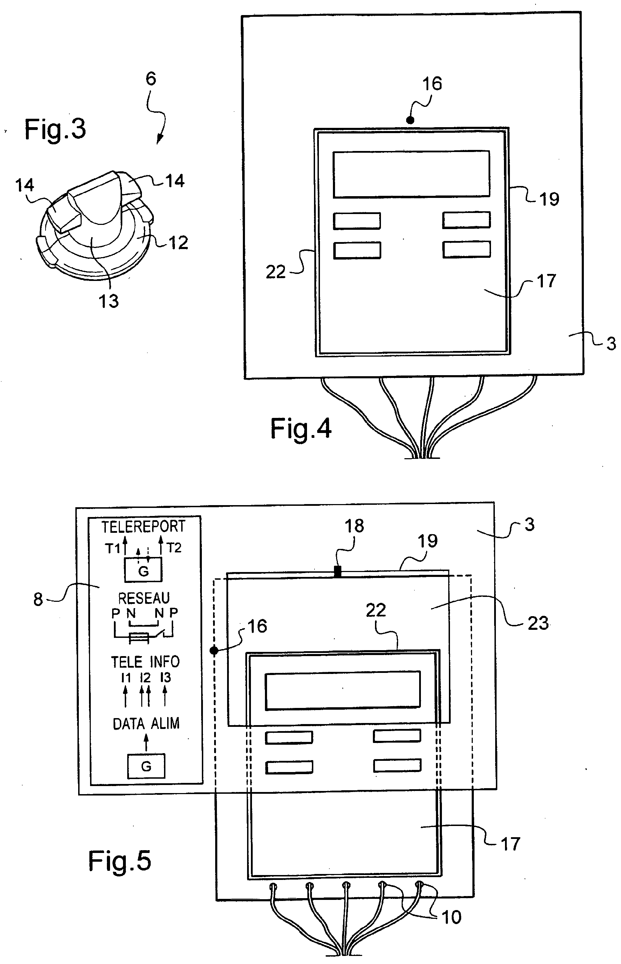

Le maintien du cache 3 en position fermée sur le boîtier 2 est réalisé à l'aide d'une vis 6 du type quart de tour. La vis 6 traverse le cache 3 en étant axialement prisonnière de celui-ci mais libre en rotation. La figure 3 représente la vis 6 qui comprend une tête 12, un corps 13 et deux saillies 14 s'étendant perpendiculairement à l'axe du corps de la vis 6 au niveau de l'extrémité libre du corps 13.

Le boîtier 2 délimite un orifice 11 agencé dans le boîtier 2 de manière à ce que lorsque la vis 6 est engagée dans l'orifice 11 et subit un quart de tour dans l'orifice, le cache 3 se trouve alors fixé au boîtier selon une position fermée recouvrant le bornier.

Le boîtier 2 délimite par ailleurs un logement 7, directement issu de moulage, apte à recevoir et à maintenir la tête de vis 6 tel qu'illustré en figure 2 qui illustre le même compteur électrique 1 que celui de la figure 1 selon une position ouverte du cache maintenu ainsi sur le boîtier 2 de manière à découvrir le boîtier 2 tout en laissant apparente une face interne du cache. La tête de vis 6 est à cette fin insérée à force dans le logement 7 maintenant alors le cache 3 dans la position ouverte. Une telle configuration permet ainsi à un utilisateur d'accéder aux informations 8 propres au montage et au câblage imprimées, gravées ou collées sur la face interne du cache 3.

Le cache 3 ainsi fixé découvre le bornier et permet l'accès aux différentes connections de câbles 10 du compteur.

On notera que la vis 6 est montée sur le cache 3 avec un jeu axial entre la vis 6 et le cache 3. La vis 6 est ainsi montée mobile axialement entre une première position dans laquelle la tête est noyée dans le cache pour permettre la fixation du cache sur le boîtier par-dessus le bornier (figure 1) et une deuxième position dans laquelle la tête est en saillie du cache pour permettre l'insertion de la tête dans le logement du boîtier assurant la fixation du cache 3 en position ouverte (figure 2).

La fixation du cache 3 en position fermée et en position ouverte est ainsi réalisée par l'utilisation de chaque côté de la vis 6 selon la configuration suivante.

La figure 4 illustre un deuxième mode de réalisation selon l'invention dans lequel le cache 3 obturant les connexions électriques du compteur habille par ailleurs le compteur 17 en définissant une façade. Le cache 3 présente une ouverture rectangulaire 19 prévue à cet effet de manière à ce que le cache entoure le cadran lorsque le cache 3 est en position fermée tel qu'illustré en figure 4. Pour cela le compteur comporte une zone d'épaulement 22 entourant le cadran et ayant une épaisseur égale à l'épaisseur du cache 3. Le cache 3 est alors fixé à une zone support 23 s'étendant immédiatement après l'épaulement 22 sur toute la périphérie du compteur 17 à l'aide d'une simple vis 16 traversant le cache 3.

Le cache 3 est ici en position fermée. En variante, le cache 3 peut être également fixé au compteur 17 par clipsage.

La figure 5 représente le cache 3 en position ouverte selon le deuxième mode de réalisation. La partie supérieure de la zone de support 23 du compteur 17 comporte un ergot 18 ou plus particulièrement une butée sur laquelle vient reposer l'un des bords de l'ouverture 19 du cache 3 de manière à ce que les informations 8 propres au montage et au câblage disposées sur la face interne du cache soient visibles par un utilisateur et que les connexions 10 électriques du compteur soient accessibles.

Pour que les connexions 10 du compteur 17 soient accessibles, le cache 3 de forme rectangulaire, disposé verticalement en longueur en position fermée selon la figure 4, est disposé horizontalement en longueur en position ouverte.

L'agencement de la zone support 23 du compteur 17 et du cache 3 en position ouverte ne permet donc pas à l'ouverture 19 d'entourer entièrement la zone support 23 du compteur 17. Par conséquent, la fixation du cache 3 sur la butée 18 est réalisée par déformation élastique du cache 3 au niveau du bord de l'ouverture 19 venant en butée sur l'ergot 18.

Bien entendu, l'invention n'est pas limitée aux modes de réalisation décrits ci-dessus et sont susceptibles de variantes qui apparaîtront à l'homme de métier sans sortir du cadre de l'invention tel que définie par les revendications.

Le maintien mécanique du cache sur le boîtier peut être assuré par tout moyen et par exemple par déformation élastique, clipsage, encliquetage, verrouillage...

## Revendications

1. Compteur électrique (1 ; 17) comportant un boîtier délimitant un bornier de connexion à des câbles et un cache amovible (3) recouvrant au moins partiellement le bornier, **caractérisé en ce que** :
- le cache amovible est agencé pour être maintenu dans une position ouverte dans laquelle le cache découvre le bornier et laisse apparente une face interne du cache pour un utilisateur situé en regard de la face avant du boîtier, et dans une position fermée dans laquelle le cache recouvre le bornier ;
- le compteur comporte un moyen de fixation (6 ; 18) agencé pour maintenir ledit cache (3) en position ouverte sur une face avant du boîtier.

2. Compteur selon la revendication 1, dans lequel le moyen de fixation du dispositif est une vis (6) de type quart de tour, prisonnière du cache, comportant un corps d'ancrage (13, 14) surmonté d'une tête (12), le corps (13) étant agencé pour maintenir le cache (3) sur le boîtier en recouvrant le bornier (10) et le boîtier comportant un logement (7) pour recevoir la tête et maintenir le cache sur le boîtier en découvrant le bornier (10).

3. Compteur selon la revendication 2, dans lequel la vis (6) est montée mobile axialement entre une première position dans laquelle la tête (12) est noyée dans le cache (3) pour permettre la fixation du cache sur le boîtier par-dessus le bornier (10) et une deuxième position dans laquelle la tête est en saillie du cache (3) pour permettre l'insertion de la tête dans le logement (7) du boîtier.

4. Compteur selon la revendication 2, dans lequel le logement et la tête ont des dimensions telles que la tête de la vis est engagée à force dans le logement.

5. Compteur selon la revendication 1, dans lequel le moyen de fixation du dispositif est une butée (18) disposée sur le boîtier (17, 22) pour retenir le cache (3) lorsque celui-ci découvre le bornier.

6. Compteur selon la revendication 5, dans lequel la butée (18) est positionnée de manière que le cache (3) soit déformé lorsque le cache est en butée et en position sur le boîtier pour laisser le bornier (10) découvert.

## Patentansprüche

1. Elektrischer Zähler (1; 17), umfassend ein Gehäuse, dass eine Klemmleiste zum Anschluss von Kabeln begrenzt, sowie eine abnehmbare Abdeckung (3), die die Klemmleiste zumindest teilweise abdeckt, **dadurch gekennzeichnet, dass**:
- die abnehmbare Abdeckung ausgebildet ist, um in einer geöffneten Position gehalten zu werden, in der die Abdeckung die Klemmleiste freilegt und eine Innenseite der Abdeckung für einen Nutzer, der sich gegenüber der Vorderseite des Gehäuses befindet, sichtbar lässt, sowie in einer geschlossenen Position, in der die Abdeckung die Klemmleiste abdeckt;
- der Zähler ein Befestigungsmittel (6; 18) umfasst, das ausgebildet ist, um die Abdeckung (3) in geöffneter Position auf einer Vorderseite des Gehäuses zu halten.

2. Zähler nach Anspruch 1, wobei das Befestigungsmittel der Vorrichtung eine in der Abdeckung gefangene Vierteldreh-Schraube (6) ist, die einen Verankerungskörper (13, 14) umfasst, über dem ein Kopf (12) angeordnet ist, wobei der Körper (13) ausgebildet ist, um die Abdeckung (3) an dem Gehäuse zu halten und dabei die Klemmleiste (10) abzudecken, und das Gehäuse eine Aufnahme (7) umfasst, um den Kopf aufzunehmen und die Abdeckung an dem Gehäuse zu halten und dabei die Klemmleiste (10) freizulegen.

3. Zähler nach Anspruch 2, wobei die Schraube (6) zwischen einer ersten Stellung, in der der Kopf (12) in der Abdeckung (3) eingebettet ist, um die Befestigung der Abdeckung an dem Gehäuse über der Klemmleiste (10) zu ermöglichen, und einer zweiten Stellung axial beweglich gelagert ist, in der der Kopf von der Abdeckung (3) vorsteht, um das Einfügen des Kopfes in die Aufnahme (7) des Gehäuses zu ermöglichen.

4. Zähler nach Anspruch 2, wobei die Aufnahme und der Kopf solche Abmessungen haben, dass der Kopf der Schraube mit Kraft in die Aufnahme hineingesteckt wird.

5. Zähler nach Anspruch 1, wobei das Befestigungsmittel zum Befestigen der Vorrichtung ein Anschlag (18) ist, der an dem Gehäuse (17, 22) angeordnet ist, um die Abdeckung (3) zu halten, wenn diese die Klemmleiste freifegt.

6. Zähler nach Anspruch 5, wobei der Anschlag (18) derart positioniert ist, dass die Abdeckung (3) verformt ist, wenn die Abdeckung in Anlage und in Position an dem Gehäuse ist, um die Klemmleiste (10) unbedeckt zu lassen.

## Claims

1. An electricity meter (1; 17) comprising a box defining a terminal block for connection to cables and a removable cover (3) covering the terminal block at least in part, the electricity meter being **characterized in that**:
- the removable cover is configured to be held in an open position in which the removable cover uncovers the terminal block and let visible an inside face of the cover for a user situated looking at the front face of the box, and in a closed position, in which the cover covers the terminal block ;
- the electricity meter includes fastener means (6; 18) arranged to hold said cover (3) in the open position on a front face of the box.

2. A meter according to claim 1, wherein the fastener means of the device comprise a quarter-turn type screw (6) that is held captive to the cover, comprising an anchoring shank (13, 14) surmounted by a head (12), the shank (13) being arranged to hold the cover (3) on the box while covering the terminal block (10), and the box including a housing (7) for receiving the head and for holding the cover on the box while uncovering the terminal block (10).

3. A meter according to claim 2, wherein the screw (6) is mounted to move axially between a first position in which the head (12) is sunk in the cover (3) so as to enable the cover to be fastened on the box over the terminal block (10), and a second position in which the head projects from the cover (3) in order to enable the head to be inserted in the housing (7) in the box.

4. A meter according to claim 2, wherein the housing and the head are of dimensions such that the head of the screw is engaged by force in the housing.

5. A meter according to claim 1, wherein the fastener means of the device comprise an abutment (18) arranged on the box (17, 22) to hold the cover (3) when it covers the terminal block.

6. A meter according to claim 5, wherein the abutment (18) is positioned in such a manner that the cover (3) is deformed when the cover is in abutment and in position on the box to leave the terminal block (10) uncovered.
